(19) Europäisches Patentamt

European Patent Office

Office européen des brevets

(11) Veröffentlichungsnummer: **0 349 966**

**A2**

(12) **EUROPÄISCHE PATENTANMELDUNG**

(21) Anmeldenummer: 89112142.8

(22) Anmeldetag: 03.07.89

(51) Int. Cl.4: **H03L 7/107 , H03L 7/10**

(30) Priorität: 08.07.88 DE 3823237

(43) Veröffentlichungstag der Anmeldung:
10.01.90 Patentblatt 90/02

(84) Benannte Vertragsstaaten:
AT BE CH DE ES FR GB GR IT LI NL SE

(71) Anmelder: **Siemens Aktiengesellschaft**
**Wittelsbacherplatz 2**
**D-8000 München 2(DE)**

(72) Erfinder: **Ernst, Wolfram, Dipl.-Ing.**
**Karl-Witthalmstrasse 9**
**D-8000 München 70(DE)**
Erfinder: **Lindwurm, Franz, Dipl.-Ing.**
**Strassbergerstrasse 103**
**D-8000 München 40(DE)**
Erfinder: **Troost, Marcel-Abraham, Dipl.-Ing.**
**Gabrielle-Münter-Strasse 25/2**
**D-8000 München 71(DE)**

(54) Verfahren zur Synchronisation eines Taktgenerators, insbesondere Taktgenerators einer digitalen Fernmeldevermittlungsstelle.

(57) Der Taktgenerator wird auf einen Referenztakt ($f_R$) aufsynchronisiert, der mit Jitter und Wander behaftet ist. Bei einer Neusynchronisation wird zunächst durch Proportionalregelung die Taktfrequenz $f_n$ des Taktgenerators möglichst schnell an diejenige des Referenztaktes herangeführt. Danach wird auf Proportional/Integralregelung umgeschaltet. Der P/J-Betrieb der Regelung beginnt mit einer niedrigen Zeitkonstanten, die stufenweise erhöht wird. Damit ist erreicht, daß die Regelschaltung nach Beginn des P/J-Betriebs relativ schnell eingeschwungen ist, sodaß ein vorübergehender Ausfall des Referenztaktes in dieser Betriebsphase nicht zu unzulässigen Abweichungen führt und Jitter- und Wanderstörungen relativ schnell abgebaut werden.

Xerox Copy Centre

## Verfahren zur Synchronisation eines Taktgenerators, insbesondere Taktgenerators einer digitalen Fernmeldevermittlungsstelle.

Die Erfindung betrifft ein Verfahren zur Synchronisation eines Taktgenerators gemäß dem Oberbegriff des Patentanspruchs 1.

Es wird demnach die Verwendung einer Phasenregelschaltung vorausgesetzt, die im Normalbetrieb als Proportional-/Integral-Regler (PI-Regler) arbeitet, dessen Verhalten der Parallelschaltung eines Proportionalreglers (P-Regler), bei dem jeder Eingangsgröße eine Ausgangsgröße zugeordnet ist, und eines Integralreglers (I-Regler) entspricht, bei dem jedem Wert der Eingangsgröße eine bestimmte Änderungsgeschwindigkeit der Ausgangsgröße gegenübersteht.

Es wird ferner vorausgesetzt, daß in der Phase einer Neusynchronisation die Regelschaltung zunächst als reiner P-Regler arbeitet, um die Frequenz des Taktgenerators möglichst schnell und nahe an die Taktfrequenz des Referenztaktes heranzuführen, und danach auf den PI-Betrieb umgeschaltet wird. Die Integrationszeitkonstante des I-Teils des PI-Reglers liegt im Normalfallbetrieb in der Größenordnung von 18 Stunden, womit gewährleistet ist, daß bei einem vorübergehenden Ausfall des Referenztaktes eine ausreichende Speichergenauigkeit vorhanden ist, die die Einhaltung der von CCITTT empfohlenen Abweichungsgrenzen der Taktfrequenz des Taktgenerators gewährleistet. Bei solchen großen Zeitkonstanten dauert es allerdings entsprechend lange bis der Integrator des PI-Reglers eingeschwungen ist, so daß bei einem Ausfall des Referenztaktes in diesem Stadium mit einer Taktfrequenz des Taktgenerators weitergearbeitet wird, die relativ schlecht mit der Frequenz des Referenztaktes übereinstimmt. Hinzu kommt, daß hochfrequente Phasenschwankungen (Jitter) und niederfrequente Phasenschwankungen (Wander), mit denen der Referenztakt aufgrund seiner Übertragung, im Falle der Synchronisation eines Taktgenerators einer digitalen Fernsprechvermittlungsstelle, also aufgrund seiner Übertragung über bestehende Digitalsignalverbindungen von anderen Vermittlungsstellen her, behaftet ist, zu fehlerhaften Frequenzablagen im Integrator führen. Diese werden zwar im Zuge des Regelprozesses abgebaut werden, wegen der erwähnten großen Zeitkonstanten allerdings entsprechend langsam.

Die Aufgabe der Erfindung besteht nun darin, ein Verfahren anzugeben, das die Verhältnisse bei der Neusynchronisation eines Taktgenerators im Hinblick auf die oben erwähnten Probleme verbessert. Diese Aufgabe wird durch ein Verfahren mit den im Kennzeichen des Patentanspruchs 1 angegebenen Merkmalen gelöst.

Wegen der bei Beginn des PI-Betriebs zunächst niedrigen Zeitkonstanten ist der Integrator der Regelschaltung relativ schnell eingeschwungen, so daß ein vorübergehender Ausfall des Referenztaktes auch in diesem Stadium nicht zu unzulässigen Abweichungen führen kann. Fehler in der Frequenzablage im Integrator, die auf Jitter und Wander zurückzuführen sind, werden ausreichend schnell abgebaut.

Gemäß einer weiteren Ausgestaltung der Erfindung erfolgt die stufenweise Erhöhung der Zeitkonstanten der Regelschaltung auf ihren Endwert jeweils bei Erreichen festgelegter Werte der relativen Frequenzgenauigkeit des Taktgenerators. Es ist hiermit gewährleistet, daß Büschelstörungen des Referenztaktes, also kurzzeitige Frequenzstörungen, nach deren Wegfall der Referenztakt wieder seine ursprünglichen Kennwerte annimmt oder Phasensprünge des Referenztaktes, auf die Regelung keinen Einfluß haben.

Nachstehend wird die Erfindung anhand eines Ausführungsbeispiels unter Bezugnahme auf eine Figur, die eine Anordnung zur Durchführung des erfindungsgemäßen Verfahrens zeigt, näher erläutert.

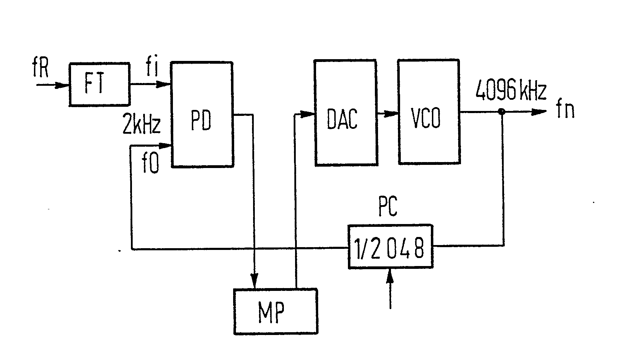

Die in der Figur dargestellte Phasenregelschaltung dient dazu, die von einem spannungsgesteuerten Oszillator VCO abgegebene Taktfrequenz fn, die beispielsweise die Taktfrequenz für eine digitale Vermittlungsstelle bildet und beispielsweise 4096 kHz beträgt, auf einen Referenztakt fR aufzusynchronisieren, der von einer anderen und vorzugsweise von einer Vermittlungsstelle her, die einer höheren Hierarchieebene des Fernmeldenetzes angehört, im Zuge bestehender Digitalsignalverbindungen geliefert wird. Dieser Referenztakt wird nach einer Frequenzuntersetzung mittels eines Frequenzteilers FT auf eine Frequenz von hier 2 kHz dem einen Eingang des Phasendiskriminators PD zugeführt, an dessen anderen Eingang das vom spannungsgesteuerten Oszillator VCO abgegebene Taktsignal, das mittels eines Frequenzteilers PC ebenfalls auf 2 kHz heruntergeteilt ist, gelangt. Der Frequenzteiler PC kann im Bedarfsfall zum Zwecke der Phasenkorrektur jeweils gezielt in seine Nullstellung gebracht werden.

Ein Mikroprozessor MP verarbeitet die vom Phasendiskriminator entsprechend der ermittelten Phasendifferenz abgegebenen Signale und errechnet daraus gemäß einem Regelalgorythmus, der dem Charakter der Regelschaltung als P-Regler oder als PI-Regler prägt, Stellwerte für den spannungsgesteuerten Oszillator, die diesem nach einer Digital-Analog-Wandlung durch einen Digital-Analog-Wandler DAC zugeführt werden.

Bei einer Neusynchronisation, die bei Inbetriebnahme eines Taktgenerators in Frage kommt, bzw. dann wenn der Referenztakt über eine längere Zeit hinweg ausgefallen war, arbeitet die Regelschaltung zunächst als reiner P-Regler, wodurch die Frequenz des spannungsgesteuerten Oszillators VCO möglichst schnell und nahe an die Frequenz des Referenztaktes herangeführt wird. Danach erfolgt eine Umschaltung auf den Betrieb als PI-Regler, der gewählt wird, weil durch einen reinen P-Regler eine bestehende konstante Frequenzdifferenz nicht völlig ausgeregelt werden kann und andererseits ein reiner I-Regler ein instabiles Verhalten zeigt. Der Integrator der Regelschaltung wird dabei auf den während des P-Betriebs erreichten Stellwert für den spannungsgesteuerten Oszillator voreingestellt. Der PI-Betrieb beginnt zunächst unter Zugrundelegung einer kleinen Zeitkonstanten, bei spielsweise 30 Minuten. Danach erfolgt beispielsweise in vier Stufen eine stufenweise Erhöhung der Zeitkonstanten bis zu einer dem endgültigen Betrieb zugrunde liegenden Zeitkonstanten von beispielsweise ca. 18 Stunden.

Sofern vorausgesetzt werden kann, daß der Referenztakt lediglich mit sinusförmigen Jitter- bzw. Wanderstörungen behaftet ist, kann diese Erhöhung in fest vorgegebenen Zeitintervallen erfolgen, da der Regelkreis als Filter wirkt und damit der spannungsgesteuerte Oszillator immer auf den Mittelwert der Referenztaktfrequenz eingestellt wird.

Wenn nun aber sogenannte Büschelstörungen also kurzzeitige erhebliche Frequenzänderungen der Referenztaktfrequenz auftreten, die durch Einstreuungen von außen beispielsweise durch Einflüsse des U-Bahnnetzes entstehen oder sonstige Phasensprünge des Referenztaktes auftreten, dann wird ein unzutreffender Mittelwert der Referenztaktfrequenz ermittelt und dementsprechend der Aufsynchronisationsprozeß beeinträchtigt. Gemäß einer weiteren Ausgestaltung der Erfindung wird daher die relative Frequenzgenauigkeit, d.h. das Verhältnis von Referenztaktfrequenz zur Taktfrequenz des spannungsgesteuerten Oszillators gemessen und erst dann wenn bestimmte Schwellwerte erreicht sind, auf den jeweils nächsten Wert der Zeitkonstanten des PI-Reglers umgeschaltet. Solange die zuvor erwähnten Büschelstörungen auftreten, werden solche Schwellwerte nicht erreicht werden können.

## Ansprüche

1. Verfahren zur Synchronisation eines Taktgenerators, insbesondere Taktgenerators einer digitalen Fernmeldevermittlungsstelle, auf einen Referenztakt, der aufgrund seiner Übertragung mit periodischen Phasenschwankungen (Jitter und Wander) behaftet ist, mit Hilfe einer Phasenregelschaltung, die im Zuge einer Neusynchronisation zunächst als Proportionalregler (P-Betrieb) arbeitet, um die Taktfrequenz des Taktgenerators möglichst schnell an den Referenztakt heranzuführen und dann auf eine Arbeitsweise als Proportional-Integralregler (PI)-Betrieb umgeschaltet wird, wobei der Integrator der Regelschaltung auf den während des P-Betriebs erreichten Stellwert für den Taktgenerator voreingestellt wird,
**dadurch gekennzeichnet,**
daß der PI-Betrieb unter Zugrundelegung einer niedrigen Zeitkonstanten beginnt, die danach stufenweise auf ihren Endwert erhöht wird.

2) Verfahren nach Anspruch 1,
**dadurch gekennzeichnet,** daß die stufenweise Erhöhung der Zeitkonstanten jeweils bei Erreichen festgelegter Werte der relativen Frequenzgenauigkeit des Taktgenerators erfolgt.